# EUROPEAN PATENT SPECIFICATION

(11) **EP 4 176 503 B1**
(45) Date of publication and mention of the grant of the patent: **12.06.2024**
(21) Application number: 21733057.0
(22) Date of filing: 03.06.2021
(51) Int. Cl.: H02J 3/32, H02J 3/48, H02J 7/00, G06F 1/26

(54) **ENERGY STORAGE ADAPTIVE AUGMENTATION FOR LOAD RESPONSE**
ANPASSUNG DER ENERGIESPEICHERUNG FÜR LASTREAKTION
AUGMENTATION ADAPTATIVE DU STOCKAGE D'ÉNERGIE POUR RÉPONSE À UNE CHARGE

(30) Priority: 01.07.2020 DK PA202070447
(43) Date of publication of application: 10.05.2023
(73) Proprietor: VESTAS WIND SYSTEMS A/S, 8200 Aarhus N (DK)
(72) Inventor: ZHAO, Chunyang, 8200 Aarhus N (DK); CHRISTENSEN, Lars Christian, 8200 Aarhus N (DK)
(74) Representative: Vestas Patents Department
(86) International application number: PCT/DK2021/050177
(87) International publication number: WO 2022/002323

(56) References cited:
- JP-A- 2020 054 040
- US-A1- 2014 091 753
- US-A1- 2017 220 086
- US-B2- 9 444 256

## Description

### BACKGROUND

### Field of the Invention

Embodiments presented in this disclosure generally relate to energy storage systems, which include various chemical batteries, capacitors, and kinetic batteries.

### Description of the Related Art

When deploying power storage devices, such as in power plants or secondary power supplies, the performance characteristics of the power storage devices change over time and as the devices are placed through charge/discharge cycles. As different power storage devices are suited differently for different loads and cycles of operation, different power storage devices can be assigned to handle different components of a power demand load, and are adapted to the use case.

Among prior art documents is US 2017/0220086 A1.

### SUMMARY

One embodiment of the present disclosure is a method comprising monitoring operational characteristics of members of the first group of power storage units and members of the second group of power storage units; monitoring demand characteristics of power demand on the storage array, wherein the first group of power storage units is activated to supply power for a first component of the power demand and the second group of power storage units is activated to supply power for a second component of the power demand; and while the members of the first group of power storage units and the members of the second group of power storage units remain installed and available to respond to the power demand on the storage array: reassigning a given member of the first group of power storage units to be a new member of the second group of power storage units in response to at least one of a change in the operational characteristics or a change in the demand characteristics wherein the method further comprising segmenting the power demand into a fast discharge component and a slow discharge component; and wherein the first group of power storage units are designated for handling the fast discharge component and the second group of power storage units are designated for handling the slow discharge component.

In another aspect with any method discussed above or below, the given member has operational characteristics matching an operational definition for the first group of power storage units despite being assigned as the new member of the second group of power storage units.

In another aspect with any method discussed above or below, the given member is reassigned based on an operational characteristic change in an existing member of the second group of power storage units that causes the existing member to be reassigned to a different group of power storage units.

In another aspect with any method discussed above or below, the existing member is reassigned to be a member of one of: the first group of power storage units; or a third group of power storage units.

In another aspect with any method discussed above or below, the given member is reassigned based on a demand characteristic change requiring fewer members to meet the power demand on the first group of power storage units.

In another aspect with any method discussed above or below, the given member is reassigned based on a demand characteristic change requiring more members to meet the power demand on the second group of power storage units.

One embodiment of the present disclosure is a system comprising: a processor; a memory device including instructions embodied therewith that when executed by the processor perform an operation comprising: monitoring operational characteristics of members of the first group of power storage units and members of the second group of power storage units; monitoring demand characteristics of power demand on the storage array, wherein the first group of power storage units is activated to supply power for a first component of the power demand and the second group of power storage units is activated to supply power for a second component of the power demand; and while the members of the first group of power storage units and the members of the second group of power storage units remain installed and available to respond to the power demand on the storage array: reassigning a given member of the first group of power storage units to be a new member of the second group of power storage units in response to at least one of a change in the operational characteristics or a change in the demand characteristics wherein the operation further comprising: segmenting the power demand into a fast discharge component and a slow discharge component; and wherein the first group of power storage units are designated for handling the fast discharge component and the second group of power storage units are designated for handling the slow discharge component.

In another aspect with any system discussed above or below, the given member has operational characteristics matching an operational definition for the first group of power storage units despite being assigned as the new member of the second group of power storage units.

In another aspect with any system discussed above or below, the given member is reassigned based on an operational characteristic change in an existing member of the second group of power storage units that causes the existing member to be reassigned to a different group of power storage units.

In another aspect with any system discussed above or below, the existing member is reassigned to be a member of one of: the first group of power storage units; or a third group of power storage units.

In another aspect with any system discussed above or below, the given member is reassigned based on a demand characteristic change requiring fewer members to meet the power demand on the first group of power storage units.

In another aspect with any system discussed above or below, the given member is reassigned based on a demand characteristic change requiring more members to meet the power demand on the second group of power storage units.

### BRIEF DESCRIPTION OF THE DRAWINGS

So that the manner in which the above recited features of the present disclosure can be understood in detail, a more particular description of the disclosure, briefly summarized above, may be had by reference to embodiments, some of which are illustrated in the appended drawings. It is to be noted, however, that the appended drawings illustrate only typical embodiments of this disclosure and are therefore not to be considered limiting of its scope, for the disclosure may admit to other equally effective embodiments. The embodiments in this disclosure are not necessarily defining the invention.

The invention is defined by the features of the independent claims 1 and 7. Preferred embodiments are defined in the dependent claims
Figure 1 illustrates an operational layout for an array of batteries connected to a load, according to embodiments of the present disclosure.
Figures 2A-2C illustrate different characterization profiles for different batteries, according to embodiments of the present disclosure.
Figure 3 illustrates a graph of lifetime usage of a battery according to two different charge profiles, according to embodiments of the present disclosure.
Figure 4 illustrates a demand division, according to embodiments of the present disclosure.
Figure 5 is a flowchart of a method of continuous battery group management, according to embodiments of the present disclosure.
Figure 6 is a flowchart of a method for handling the reassignment of classified batteries between different groups in an array, according to embodiments of the present disclosure.
Figure 7 is a flowchart of a method for managing power storage and discharge from a storage array including a first group of power storage units (e.g., batteries 150) and a second group of power storage units, according to embodiments of the present disclosure.
Figure 8 is a block diagram of a controller unit, according to embodiments of the present disclosure.

To facilitate understanding, identical reference numerals have been used, where possible, to designate identical elements that are common to the figures. It is contemplated that elements disclosed in one embodiment may be beneficially utilized on other embodiments without specific recitation.

### DESCRIPTION OF EXAMPLE EMBODIMENTS

In various deployments of an array of energy storage systems (ESS), such as an array of chemical batteries, a controller unit segments or sub-divides the individual ESS into groups based on the operational characteristics of those ESS and the power storage needs placed on the array by a load (e.g., total power level, responsiveness, efficiency in operation). The present disclosure provides for adaptive augmentation for load response, where a controller unit updates which power storage devices are grouped to respond to various portions of the load without having to uninstall/reinstall those devices. Additionally, the reassigned devices may retain the operational characteristics that would otherwise classify them in an original grouping. However, based on the needs of the array (e.g., the overall demand profile or the characteristics of other storage devices), the reassigned devices operate to meet a different portion of the load with a new group of storage devices.

For example, a given ESS classified as a class A ESS can normally be grouped with other class A ESS that share an operational profile with one another (e.g., fast response time, but low energy storage capacity), but can be regrouped with several class B ESS that share an operational profile with one another (e.g., slow response time, but high energy storage capacity), but not with the given ESS. The controller unit can regroup the given ESS with the class *B* ESS despite the given ESS remaining classified as a class A ESS (and displaying all of the associated operational characteristics of a class A ESS) to ensure that the array has sufficient ESS assigned to each of a fast-response group (including the class A ESS) and a high storage capacity group (including the class B ESS and the given ESS).

The controller unit continuously monitors the performance of the ESS in the array and the demand requirements placed on the array to reevaluate and adjust which ESS are assigned to which group. For example, if a class A ESS degrades to a class C ESS, the controller unit can identify a class B ESS to replace the class A ESS with during operations of the array so that when the class A ESS are cycled, the identified class B ESS also cycles. In another example, if the controller unit identifies that the load requires a greater number of ESS to respond to demand as class A ESS, the controller unit identifies one or more non-class A ESS to operate as class A ESS until such time as the demand profile changes to require fewer class A ESS or more class A ESS are installed in the array.

When multiple ESS are classified in a first group and the controller unit identifies that at least one ESS in the first group is to be operated as part of a different group, the controller unit selects which individual ESS to re-assign based on a variety of factors. In some embodiments, the individual ESS that is reassigned is identified as the ESS in the first group that has operational characteristics closest to those of the different group, the ESS closest to a service or replacement date, the ESS that is simplest to replace, etc.

### EXAMPLE EMBODIMENTS

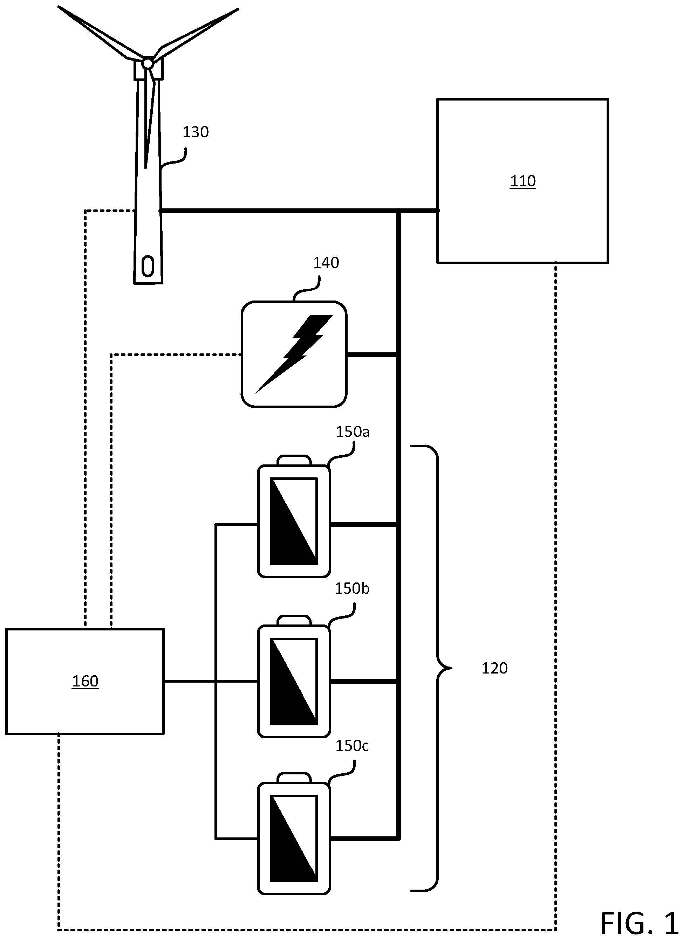

Figure 1 illustrates an operational layout for an array 120 of batteries 150 connected to a load 110, according to embodiments of the present disclosure. In various embodiments, the load 110 may be a public utility grid, a private sub-grid (e.g., a building or campus, whether normally connected to a public utility grid or not), or a sub-set of the a private sub-grid (e.g., circuits for computers in a server room of a building, but not other circuits.) The load 110 draws power from one or more power sources including renewable power sources 130 (e.g., wind turbine generators, photovoltaic generators, hydroelectric generators), fueled power sources 140 (e.g., generators using diesel, propane, natural gas, hydrogen, biomass, etc.), and a battery array 120. In various embodiments, the load 110 may draw power from one or more of the renewable power sources 130, fueled power sources 140, and the battery array 120 in addition to or to replace of a connection to an external power grid (not illustrated).

The battery array 120 includes a plurality of energy storage systems, which may be charged from power supplied from an external electric grid, one or more of the renewable power sources 130 or fueled power sources 140, or a different member of the battery array 120. For example, a battery array 120 can include a first battery 150a (generally or collectively, battery 150), a second battery 150b, a third battery 150c, etc. Although the batteries 150 used in the battery array 120 are often chemical batteries, the battery array 120 can include various capacitors or mechanical batteries (e.g., flywheels) in addition to the chemical batteries 150.

Each battery 150 of the battery array 120 may have a different construction or chemistry, have a different specified power rating, or be at a different position in a life cycle than other batteries 150 in the battery array 120. For example, a first battery 150a may be a newly installed lead-acid battery with A Ah (Amp hours) of rated capacity, the second battery 150b may be a lead-acid battery with B Ah of rated capacity that has been installed (and in use) for several months, and the third battery 150c may be a Nickel Cadmium (NiCd) battery with C Ah of rated capacity that has been installed (and in used) for several months. As will be appreciated, the battery array 120 can include various numbers of batteries 150 that are different from one another, and can be individually charged, discharged, or replaced/serviced, and the number of batteries 150 can increase or decrease as needed to serve the load 110 and/or replace/service existing batteries 150 in the battery array 120.

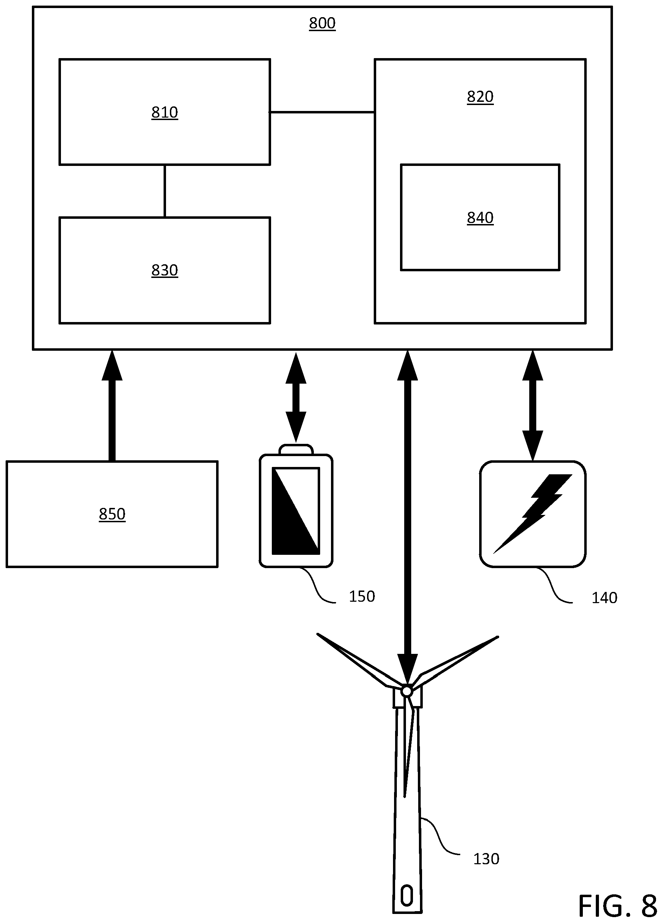

A battery controller 160 is provided to monitor and to control when individual batteries 150 charge or discharge (i.e., cycle). The battery controller 160, which may be a computing device such as that described in greater detail in Figure 8, is in communication with each battery 150 of the battery array 120 to monitor and control the charging and discharging of the individual batteries 150. In various embodiments, the battery controller 160 is also in communication with the load 110 (or one or more power-draw sensors associated with the load 110), the renewable power sources 130, and the fueled power sources 140 to determine the power output capacity of the generators, a current power output level from the generators, and/or the amount of power being drawn by the load 110.

Although described in relation to Figure 1 as individual batteries 150, each battery 150 can be representative of a group of batteries 150 that are controlled jointly by the battery controller 160. For example, a first group of batteries 150

As will be appreciated, the battery controller 160 can segment or sub-divide the array 120 into more than or fewer than three groups in various embodiments.

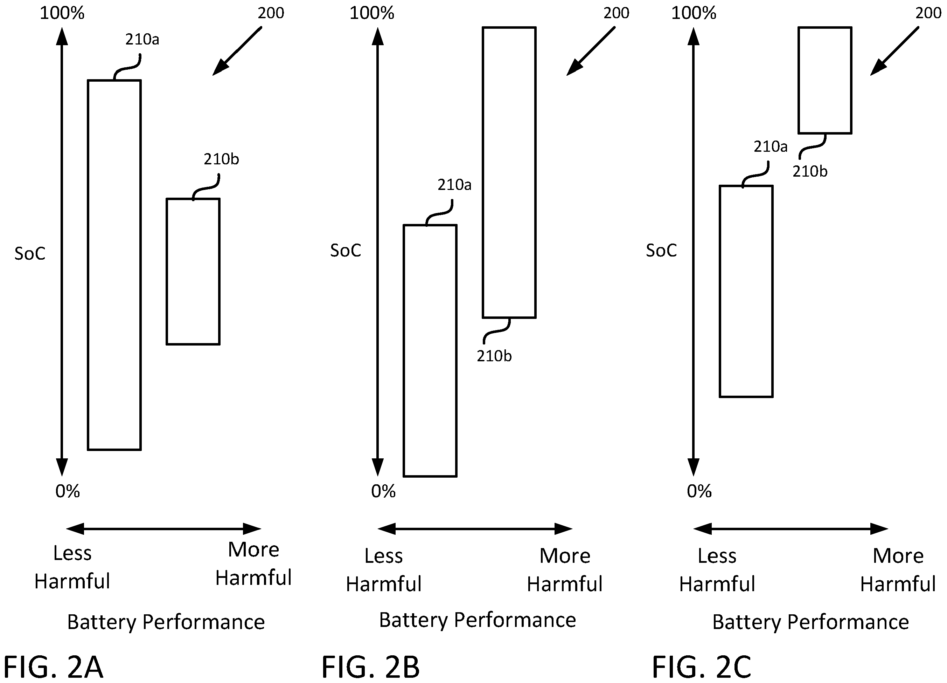

Figures 2A-2B illustrate different characterization profiles for different batteries 150a-c, according to embodiments of the present disclosure. Depending on how a given battery 150 is cycled from a first SoC to a second SoC (and back to the first SoC), the capabilities of that battery 150 are affected. Cycling a battery 150 can change the overall storage capacity, response time (how quickly a battery 150 can discharge or charge), efficiency of storage, etc. Different batteries 150, based on the construction or their previous use can exhibit different characterizations 210 with different effects on the capabilities of those batteries 150. In each of Figures 2A-2C, a characterization 200a-c of a given battery 150 is shown with a first charge profile 210a that is less harmful to the capabilities of the battery 150 than a second charge profile 210b that is more harmful to the capabilities of the battery 150.

In Figure 2A, the first characterization 200a shows a contained arrangement, where the SoC range of a more harmful second charge profile 210b is contained within with the SoC range of the less harmful first charge profile 210a. For example, the first charge profile 210a indicates a cycle from 60% to 20% SoC and the second charge profile 210b indicates a cycle from 40% to 30% SoC.

In Figure 2B, the second characterization 200b shows an intersected arrangement, where the SoC range of a more harmful second charge profile 210b intersects with the SoC range of the less harmful first charge profile 210a. For example, the first charge profile 210a indicates a cycle from 60% to 0% SoC and the second charge profile 210b indicates a cycle from 100% to 40% SoC; having an intersection between 40% and 60% SoC. In another example, the first charge profile 210a can have a cycle from 100% to 40% SoC and the second charge profile 210b can have a cycle from 60% to 0% SoC; also having an intersection between 40% and 60% SoC, but reversed positions of the more/less harmful profiles compared to the first example.

In Figure 2C, the third characterization 200c shows a separated arrangement, where the SoC range of a more harmful second charge profile 210b does not intersect with the SoC range of the less harmful first charge profile 210a. For example, the first charge profile 210a may indicate a cycle from 75% to 30% SoC and the second charge profile 210b may indicate a cycle from 100% to 90% SoC; having a separation between 75% and 90% SoC. In another example, the first charge profile 210a may indicate a cycle from 100% to 90% SoC and the second charge profile 210b may indicate a cycle from 75% to 30% SoC; also having a separation between 75% and 90% SoC, but reversed positions of the more/less harmful profiles compared to the first example.

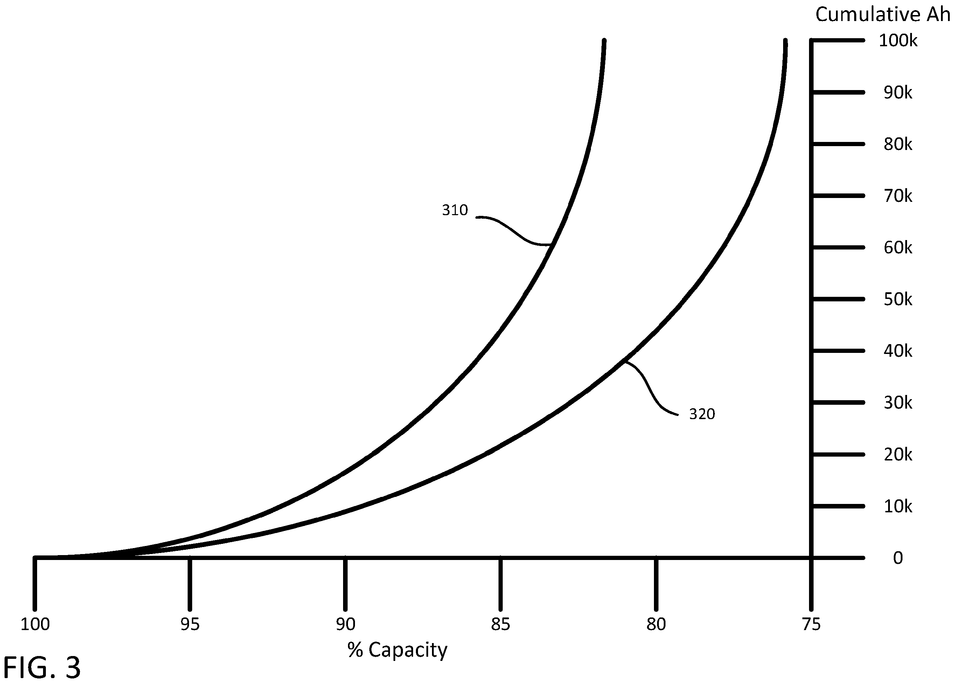

Figure 3 illustrates a graph of lifetime usage of a battery 150 according to two different charge profiles, according to embodiments of the present disclosure. A first lifetime curve 310 illustrates the percent capacity of a battery 150 over one hundred thousand (100k) Amp Hours (Ah) cumulatively delivered to a load 110 according to a first charge profile. Similarly, a second lifetime curve 320 illustrates the percent capacity of the same battery 150 over 100k Ah cumulatively delivered to a load 110 according to a second charge profile. As will be appreciated, the first and second lifetime curves 310, 320 illustrated in Figure 3 are idealized; various jumps or dips in capacity may occur when responding to demand from an actual load 110, and the capacity may also decay as a function of time even when the battery 150 is not cycled.

The first lifetime curve 310 illustrates a capacity of the battery 150 when operated according to a highest-rated or "least-harmful" charge profile (e.g., the first charge profile 210a from Figures 2A-2C), whereas the second lifetime curve 320 illustrates a capacity of the battery 150 when operated according to a lowest-rated or "most-harmful" charge profile (e.g., the second charge profile 210b from Figures 2A-2C). Accordingly, by operating the battery 150 to the highest-rated charge profile, the battery controller 160 can prolong the life of the battery 150 relative to operating the battery 150 according to the lowest-rated charge profile. As will be appreciated, the battery controller 160 can operate a battery 150 according to one of several charge profiles that are intermediate in the level of harm to the battery 150 compared to the most/least harmful charge profiles, and have and intermediate effect on the lifetime of the battery 150. Accordingly, such intermediate charge profiles would have a lifetime curve (not illustrated) somewhere between the first and second lifetime curves 310, 320.

Generally, the battery controller 160 operates batteries 150 according to the highest-rated charge profiles known for those batteries 150 to thereby prolong the lifespan of those batteries 150. Additionally, the battery controller 160 operates batteries 150 that are classified as sharing a highest-rated charge profile in a shared group with one another. For example, if the array 120 includes N batteries 150 with a first charge profile, and M batteries 150 with a second charge profile, the battery controller 160 can cycle the N batteries with the first charge profile together as a first group and cycle the M batteries with the second charge profile together as a second group, where each group is controlled independently of the other.

In some embodiments, the batteries 150 in the array 120 are initially selected to have various charge profiles to meet different needs for the load 110 and preserve the operational capabilities of those batteries 150. For example, when the load 110 has a long and steady demand, batteries 150 with highest-rated charge profiles with larger ranges in SoC can be selected (e.g., from 80% to 20% SoC rather than from 60% to 40% SoC). Similarly, when the load 110 has a short and bursty demand, batteries with highest-rated charge profiles with smaller ranges in SoC can be selected (e.g., from 80% to 60% or 40% to 20% SoC rather than from 80% to 20% SoC). In various embodiments, the batteries 150 in the array 120 are initially selected to have other characteristics (e.g., ease of maintenance, cost, speed of discharge or charge, having a particular manufacturer, etc.) and the charge profile is a secondary consideration for how to cycle a given battery 150. As will be appreciated, the array 120 can include a mix of different batteries 150 (and other ESS) that are selected to handle different portions of the demand from the load 110 so that the battery controller 160 can prolong the overall life of the array 120 under various circumstances.

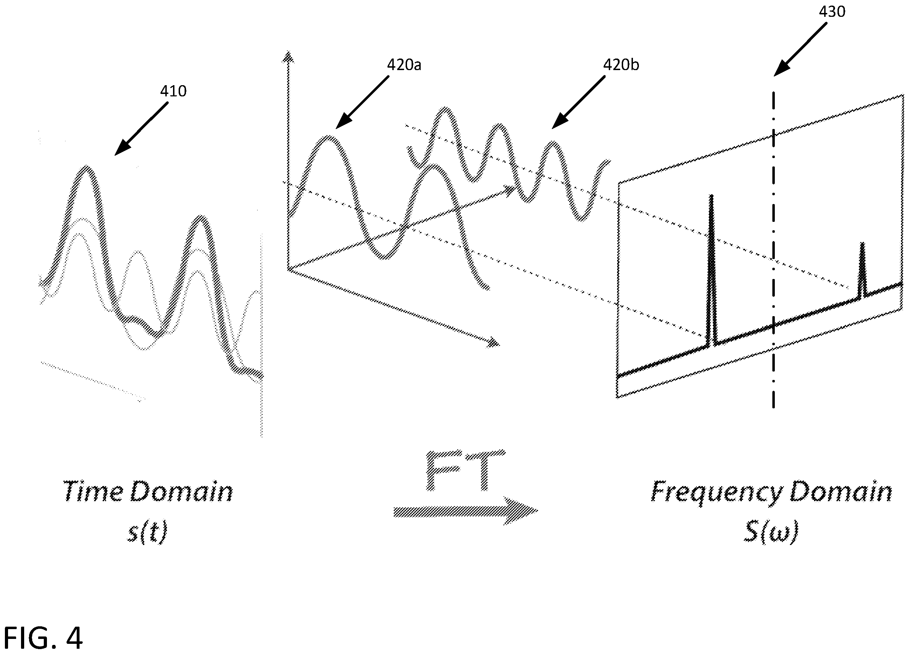

Figure 4 illustrates a demand division, according to embodiments of the present disclosure. When viewed in the time domain, a total demand curve 410 of the demand on the array 120 can be divided into a first sub-demand curve 420a and a second sub-demand curve 420b that combine to form the total demand curve 410. When analyzed in the frequency domain (for example, by taking the Fourier transform of the total demand curve 420), the periodic components of each of the first and second sub-demand curves 420a-b become more apparent. In various embodiments, the battery controller 160 can assign different groups of batteries 150 to respond to different parts of the total demand curve 410.

In various embodiments, the battery controller 160 can set a frequency threshold 430 so that a first group of batteries 150 handles the portions of the demand with frequencies below the frequency threshold 430 and a second group of batteries handles the portions of the demand with frequencies above the frequency threshold 430. In one example, a first battery group composed of chemical batteries with slow response times is assigned to handle the first sub-demand curve 420a while a second battery group composed of capacitors is assigned to handle the second sub-demand curve 420b.

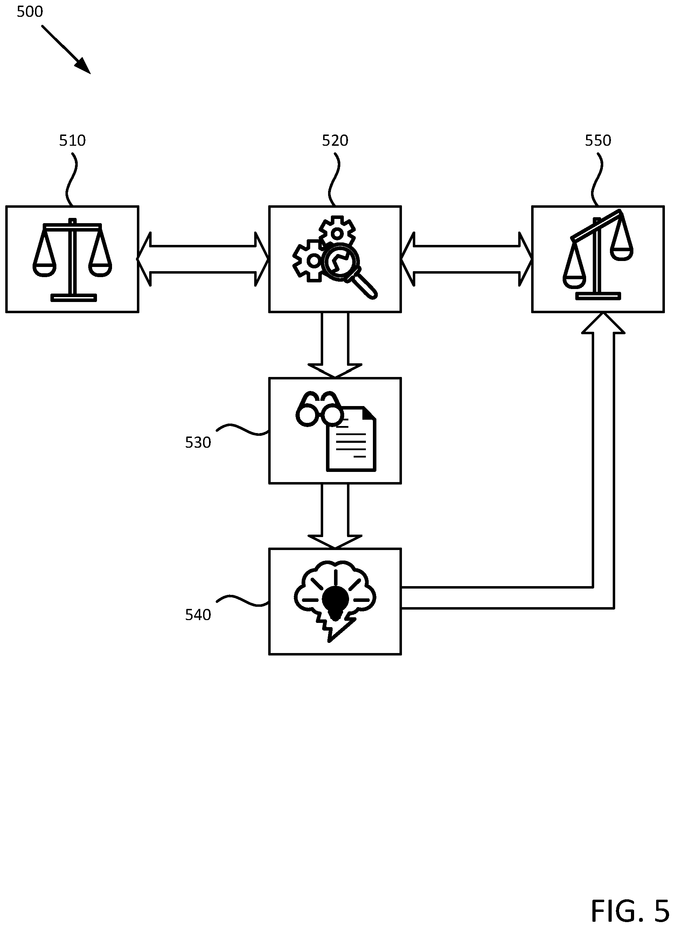

The battery controller 160, however, is not limited to use the batteries 150 as initially provisioned to the array 120, but rather can augment or diminish the membership of the various groups to include more or fewer batteries 150 from the array 120 based on the load profile on the array 120. Figure 5 is a flowchart of a method 500 of continuous battery group management, according to embodiments of the present disclosure.

Method 500 initially begins with block 510, where a user scales, sizes, and/or segments the array 120 based on a user-specified load profile for an intended use case of the array 120. The user-specified load profile can include an initially specified load profile for the load 110 served by the array 120, and can include updated load profiles based on observed and predicted load behaviors from blocks 520-550 of method 500 and/or the observed battery behaviors (e.g., reacting to a battery 150 going offline for repairs or a newly installed battery 150). In various embodiments, the user updates the load profile whenever a battery 150 is installed, uninstalled, repaired, replaced, and/or re-characterized. Additionally or alternatively, the user can update the load profile when the use case of the array 120 changes. For example, when the array 120 is used to supplement or smooth power generation or provide ride through or black start support to a power plant, the user can update the load profile in response to adding or removing (e.g., for maintenance) one or more generators to/from the power plant.

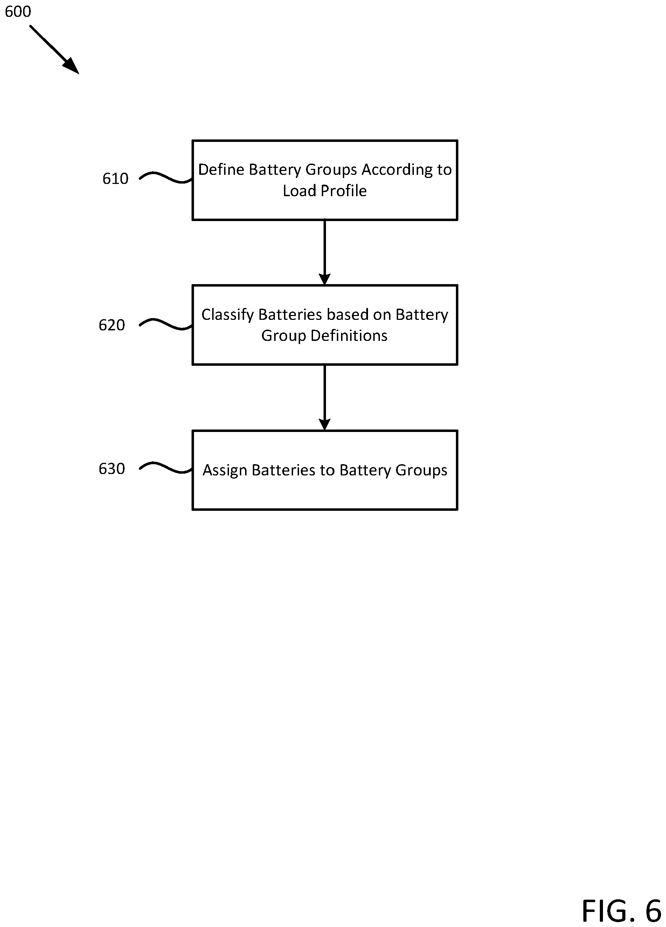

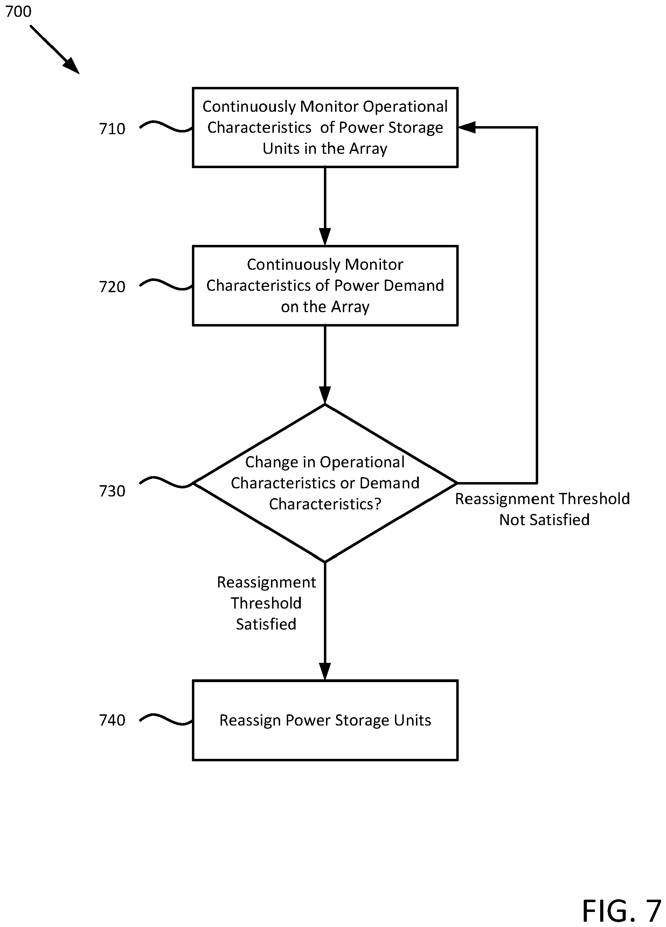

As part of establishing the load profile per block 510 (and updating the load profile per block 550), in one embodiment, the battery controller 160 classifies the batteries 150 into various groups to be controlled together. As the batteries 150 deteriorate due to use, the battery controller 160 can re-classify the batteries 150 into different groups, and as the load profile changes, the battery controller 160 can re-group the batteries 150, as is described in greater detail in regard to Figures 6 and 7.

At block 520, the battery controller 160 recognizes and manages the array 120 to respond to power demand from the load 110 according to the currently active load profile. In various embodiments, the battery controller 160 cycles different groups of batteries 150 to respond to different portions of the demand from the load 110, where the groups are set according to blocks 510 and/or 550. The groups identify several batteries 150 from the array 120 that are cycled according to a shared charge profile. For example, the batteries 150 assigned to a first group cycle according to a first charge profile, whereas the batteries 150 assigned to a second group cycled according to a second charge profile. In various embodiments, the battery controller 160 sets the charge profile for each group to be the highest rated charge profile for the class of batteries 150 in each group.

At block 530, the battery controller 160 analyzes the performance of the batteries 150 in responding to the power demand to monitor and assess the health of the batteries 150. The battery controller 160 notes various features of the operational characteristics of the batteries 150, including the states of charge that the batteries 150 cycled between, a speed of discharge/charge of the batteries 150, an amount of power stored in the batteries 150, and the like. The health assessment allows the battery controller 160 to re-classify one or more batteries 150 that have operation characteristics that match a different class than the batteries 150 were previously classified in. For example, at installation, a given battery 150 may have operational characteristics that classify that battery 150 as a class A battery, but as the battery 150 ages and performs charge/discharge cycles, the operational characteristics of the battery 150 change. Accordingly, the battery controller 160 can re-classify the example battery 150 from a class A battery to a class B battery, from a class B battery to a class C battery, etc., until the battery 150 is uninstalled or marked as non-functional.

At block 540, the battery controller 160 predicts future demand characteristics on the array 120 from the load 110. In various embodiments, the battery controller 160 monitors and analyzes the demands placed on the array 120 over several historic charge/discharge cycles to identify trends in the demand from the load 110, and extrapolates those trends to predict future demand on the array 120.

At block 550, the battery controller 160 updates the array segmentation based on the battery health assessments and predicted demand characteristics. The battery controller 160 uses the health assessments of the batteries 150 (per block 530) in predicting how the array 120 can respond to the predicted demand (per block 540). Changes in the capacity or classification of the array 120 and/or changes in predicted demand versus current demand can cause the battery controller 160 to updated how the array is segmented into various battery groups to handle portions of the demand.

For example, when a battery 150 is reclassified from a class A battery to a class B battery, the array 120 will have fewer class A batteries to react to a first portion of the demand served by class A batteries. Accordingly, when the predicted first portion remains substantially the same to the current first portion, or increases relative to the current first portion, the battery controller 160 updates the load profile for the array 120 to include non-class A batteries in the group serving the first portion of the demand. In another example, when a class B battery is re-classified as a class C battery, and the predicted demand on the group of class B batteries is predicted to remain substantially the same or increase, the battery controller 160 can reassign a class A or a class C battery to the group of class B batteries to compensate for the loss of capacity from reclassifying the class B battery.

Additionally or alternatively, when the portion of the demand served by a given group of batteries (e.g., the class A batteries) is predicted to increase or decrease beyond a threshold value, the battery controller 160 can update the segmentation of the array 120 to place batteries 150 of different classes into a shared group. For example, when a first portion of the demand served by a first group of nominally class A batteries increases beyond the ability of the class A batteries to handle the predicted demand, the battery controller 160 identifies one or more class B/C/etc. batteries 150 to include in the first group for cycling as a class A battery, despite the potential negative effects of cycling a non-class A battery according to the highest-rated charge profile of a class A battery. In another example, when a first portion of the demand served by a first group of nominally class A batteries decreases beyond a threshold amount based on the predicted demand, the battery controller 160 identifies one or more class A batteries to reassign to a different group. Reassigning the class A batteries can allow the remaining class A batteries in the first group to fully cycle based on the highest-rated charge profile, while the reassigned batteries 150 can be used in a long-term storage group, in an uncharged group, in a secondary instance of the first group (e.g., to cycle each group fewer times), or in different group with a different charge profile to augment the power storage capacity of that different group.

Figure 6 is a flowchart of a method 600 for handling the reassignment of classified batteries 150 between different groups in an array 120, according to embodiments of the present disclosure. Method 600 begins at block 610, where the battery controller 160, according to a load profile. Each battery group is associated with one category of operational characteristics for batteries 150 (or other ESS) in the array 120. For example, a first battery group can be associated with long term power storage and the batteries 150 assigned to the first battery group are maintained at a high SoC for long periods of time and have a highest rated charge profile that has a SoC cycle of 90% to 20%. In contrast, a second battery group can be associated with a quick-response discharge and the batteries 150 assigned to the second battery group have a highest rated charge profile that has SoC cycles of 80% to 60% and 40% to 20%. As will be appreciated the long term storage and quick-response discharge are just two examples of the plurality of categories that the battery controller 160 can associated with a given battery group.

At block 620, the battery controller 160 classifies each battery 150 belonging to the battery array 120 into the categories used to define the battery groups (per block 610). For example, N batteries 150 of the array 120 can be classified as class A batteries that belong of a first group and M batteries 150 of the array 120 can be classified as class B batteries that belong to a second group. Accordingly, the battery controller 160 identifies which batteries 150 can be operated in which group according a highest-rated charge profile, so that the operational profile of the group (is met by batteries 150 (and other ESS) that will retain the characteristics needed to meet that demand for as long or as efficiently as possible. For example, batteries with higher-rated charge profiles for larger and less frequent charge cycles can be classified with a first group defined for long term storage with larger and less frequent charge cycles, whereas batteries 150 with high-rated charge profiles for smaller and more frequent charge cycles can be classified with a second group defined for quick-discharge storage with smaller and more frequent charge cycles.

At block 630, the battery controller 160 assigns the batteries 150 to the groups based the operational characteristics, including the charge profiles, of the batteries 150 matching the intended operational profile for the group and the total demand on the array 120. For example, the battery controller 160 can initially assign a first plurality of batteries 150 classified into a first category to a first battery group associated with the first category and a second plurality of batteries classified into a second category to a second battery group associated with the second category.

However, when the initial assignment results in a given group not having enough capacity to meet the portion of predicted demand from the load that the group is defined to meet, the battery controller 160 can reassign batteries 150 from one group to another, despite the reassigned battery 150 having a different charge profile than the new group to which that battery 150 is reassigned. Continuing the example, in response to a first battery group satisfying a first demand threshold, and the second battery group not satisfying a second demand threshold, the battery controller 160 reassigns a given battery of the first plurality of batteries to the second battery group, wherein the given battery remains classified in the first category.

As will be appreciated, this reassignment results in the reassigned battery 150 being operated according to a charge profile other than the highest-rated charge profile for that battery 150. The battery controller 160 selects which battery 150 to reassign to a non-matching group to preserve the ability of each group to best meet the predicted demand on that group. Accordingly, if reassigning a battery 150 from a first group to a second group results in the first group having insufficient capacity to meet predicted demand, the battery controller 160 may prioritize assigning a battery 150 from a third, fourth, fifth, etc. group to the second group rather than reassigning a battery 150 from the first group. Additionally, the battery controller 160 may select an individual battery 150 based on the ease of replacement of that battery 150, a similarity in size and/or range to the highest-rated charge profile of the individual battery 150 to the charge profile used by the new group (e.g., for a group with a charge profile of 80%-40% SoC, selecting a battery 150 with a highest-rated charge profile of 70%-30% SoC rather than a battery 150 with a highest-rated charge profile of 60% to 20%), an age of the individual battery 150 (e.g., selecting a battery 150 for reassignment that is closer to replacement than another unselected battery 150), or the like.

Figure 7 is a flowchart of a method 700 for managing power storage and discharge from a storage array 120 including a first group of power storage units (e.g., batteries 150) and a second group of power storage units, according to embodiments of the present disclosure.

Method 700 begins at block 710, where a battery controller 160 continuously monitors operational characteristics of members of a plurality of groups of power storage units. The operational characteristics can include a current SoC, a current power capacity, a current highest-rated charge profile (and other charge profiles), a date of installation, and the like. In various embodiments, the battery controller 160 monitors the usage of the power storage units including how long the power storage units have been installed in the array 120, how long the power storage units have gone since last being cycled, what level of charge the power storage units are storing and for how long, and the like.

At block 720, the battery controller 160 continuously monitors demand characteristics of power demand on the storage array 120. In various embodiments, the power demand includes several different components that are served by different groups of the power storage units. For example, the battery controller 160 activates (e.g., discharges) a first group of power storage units to supply power for a first component of the power demand and activates a second group of power storage units to supply power for a second component of the power demand. In various embodiments, the battery controller 160 uses the continuously monitored demand characteristics to identify trends in demand from the load 110 to predict future demand from the load. In various embodiments, the battery controller 160 segments the power demand into a fast discharge component and a slow discharge component (e.g., based on a frequency domain analysis of the demand characteristics) so that different groups of power storage units are designated for handling the fast discharge component and the slow discharge component.

At block 730, the battery controller 160 identifies whether a change in the operational characteristics of the power storage units (monitored per block 710) and/or a change in the demand characteristics from the load 110 (monitored per block 720) satisfy a reassignment threshold. In response to neither the change in operational characteristics nor the demand characteristics satisfying the reassignment threshold, method 700 returns to block 710. Although illustrated as a loop in Figure 7, in various embodiments, blocks 710, 720, and 730 are performed in parallel with one another. In response to at least one of the change in operational characteristics or the demand characteristics satisfying the reassignment threshold, method 700 proceeds to block 740.

The reassignment threshold is based on the capabilities of various groups of power storage units and the predicted demand on each of those various groups.

In some embodiments, the reassignment threshold is satisfied when a change in either the capabilities of a group (e.g., one or more members being removed or reassigned from the group) or the predicted demand on that group results in the group having less capacity than the predicted demand on that group. Stated differently, the reassignment threshold can be based on a demand characteristic change or capability change requiring more members of a group of power storage units to meet the power demand on the that group of power storage units. For example, when a predicted demand on a group is 1*X* Ah, and the group transitions from having *4X* Ah of capacity to 2*X* Ah of capacity or the predicted demand increases to 2*X* Ah, the reassignment threshold is not satisfied as demand is less than or equal to the capacity of the group. In another example, when the predicted demand increases from 1*X* Ah to 3*X* Ah and the capacity of the group remains at 1*X* Ah, the reassignment threshold is satisfied. Similarly, when predicted demand remains at 1*X* Ah, and the capacity of the group decreases to 0.5*X* Ah, the reassignment threshold is satisfied.

In various embodiments, the reassignment threshold is satisfied when a change in either the capabilities of a group (e.g., one or more members being added to the group) or the predicted demand on that group results in the group having greater capacity than the predicted demand on that group. Stated differently, the reassignment threshold can be based on a demand characteristic change requiring fewer members of a group of power storage units to meet the power demand on the that group of power storage units. For example, when the predicted demand falls below a predefined ratio relative to the capabilities of the group, one or more members of the group can be reassigned (or left inactive or in a 'reserve' group). In some embodiments, the predefined ratio is set equal to the capabilities of one battery 150 assigned to the group, so that when the group has *X* batteries 150 having *XY* Ah of capacity, but the predicted demand calls for (*X-1*) *Y* Ah of capacity, the battery controller 160 reassigns one battery 150 so that the group has *X-*1 members and (*X*-1)*Y* Ah of capacity. In another example, when the group has 2*X* batteries 150 having *2XY* Ah of capacity, but the predicted demand calls for *XY* Ah of capacity, the battery controller 160 creates a new group and assigns half of the batteries 150 in the existing group to the existing group and half to the new group so that each group has *X* members and *XY* Ah of capacity.

At block 740, the battery controller 160 reassigns a given member of a first group of power storage units to be a new member of a second group of power storage units. The battery controller 160 performs block 740 while the members of the various groups of power storage units remain installed in the array 120 and remain available to respond to the power demand on the storage array 120. Stated differently, the reassignment of a given member to a different group is performed programmatically, without uninstalling or reinstalling the given member power storage unit in a different physical location or rerouting any wiring or cables associated with the given power storage unit. Once reassigned, the given power storage unit operates according to the charge profile set for the group, even though that power storage unit may be operating at a less than ideal charge cycle for the operational lifetime of that power storage unit.

As will be appreciated, various changes in the array 120 and/or the load 110 can result in the reassignment threshold being satisfied in different ways, which can result in the battery controller 160 perform different or multiple reassignments of power storage units between groups. For example, when the battery controller 160 identifies that an existing member of a first group has degraded in capabilities, the battery controller 160 can reassign a power storage unit from a second group to the first group to compensate for the degradation in the existing member. In some embodiments, the battery controller 160 reassigns and or reclassifies the degraded existing member to the different group (e.g., the group that the newly assigned power unit was reassigned from or a third group) or leaves the degraded power storage unit in the first group.

In various embodiments, the reassigned power storage unit remains classified as a power storage unit that would ordinarily be assigned to a different group based on the associated operational characteristics of that power storage unit. Stated differently, the reassigned member has operational characteristics matching an operational definition for the prior group of power storage units despite being assigned as the new member of the new group of power storage units. For example, the battery controller 160 reassigns a class A battery from a group made up of exclusively class A batteries to a group made up of exclusively class B batteries (but for the reassigned class A battery) and operates the reassigned class A battery as a class B battery. In another example, the battery controller reassigns a class A battery from a group made up of exclusively class A batteries to a group made up of class A, B, C, and D batteries that are operated without a charge profile tailored to extend the operational lifetime of a specific battery class, but rather a charge profile designed to improve the responsiveness of the array 120 as a whole. As will be appreciated, once reassigned, the power storage unit cycles according to the charge profile of the new group, regardless of the effects on the reassigned power storage unit, although the battery controller 160 can select which power storage unit to reassign based on a similarity of the charge cycles of the old and new groups.

After reassigning the power storage unit, method 700 returns to block 710 to continue monitoring the array 120 and adjusting membership in the various operation groups of energy storage units within the array 120.

Figure 8 is a block diagram of a controller unit 800 as may be used in a battery controller 160 to control several batteries 150 in a battery array 120 and/or one or more generators (via a power plant controller, which may also be a controller unit 800), according to one or more embodiments. The controller unit 800 includes one or more computer processors 810 and a memory 820. The one or more processors 810 represent any number of processing elements that each can include any number of processing cores. The memory 820 can include volatile memory elements (such as random access memory), non-volatile memory elements (such as solid-state, magnetic, optical, or Flash-based storage), and combinations thereof. Moreover, the memory 820 can be distributed across different mediums (e.g., network storage or external hard drives).

As shown, the one or more processors 810 are communicatively coupled with a communication system 830 to send/receive communication via fiber optic cables, electrical wires, and/or radio signals with various sensors 850 and other controller units 800 associated with the batteries 150. In some embodiments, the various sensors 850 are linked to the batteries 150 under the control of the controller unit 800. In other embodiments, the various sensors 850 are independent from the batteries 150 under the control of the controller unit 800. For example, a controller unit 800 in control of several batteries 150 may send discharge or charge commands to the batteries 150 (or control circuity associated therewith) and receive sensor data from various voltage/current level, temperature, humidity, etc. sensors that are not associated with a particular battery 150.

The memory 820 may include a plurality of "modules" for performing various functions described herein. In one embodiment, each module includes program code that is executable by one or more of the processors 810. However, other embodiments may include modules that are partially or fully implemented in hardware (i.e., circuitry) or firmware. The memory 820 includes a battery characterization logic 840 that enables the controller unit 800 to test the various batteries 150 and build various test profiles and operational profiles for those batteries, which can be stored in the memory 820 for application in controlling the various batteries 150 and/or performing further tests on the batteries 150.

In the preceding, reference is made to embodiments presented in this disclosure. However, the scope of the present disclosure is not limited to specific described embodiments. Instead, any combination of the features and elements provided above, whether related to different embodiments or not, is contemplated to implement and practice contemplated embodiments. Furthermore, although embodiments disclosed herein may achieve advantages over other possible solutions or over the prior art, whether or not a particular advantage is achieved by a given embodiment is not limiting of the scope of the present disclosure. Thus, the aspects, features, embodiments and advantages described herein are merely illustrative and are not considered elements or limitations of the appended claims except where explicitly recited in a claim(s).

As will be appreciated by one skilled in the art, the embodiments disclosed herein may be embodied as a system, method or computer program product. Accordingly, aspects may take the form of an entirely hardware embodiment, an entirely software embodiment (including firmware, resident software, micro-code, etc.) or an embodiment combining software and hardware aspects that may all generally be referred to herein as a "circuit," "module" or "system." Furthermore, aspects may take the form of a computer program product embodied in one or more computer readable medium(s) having computer readable program code embodied thereon.

The present invention may be a system or a method.

Aspects of the present disclosure are described with reference to flowchart illustrations and/or block diagrams of methods, apparatus (systems) and computer program products according to embodiments presented in this disclosure. It will be understood that each block of the flowchart illustrations and/or block diagrams, and combinations of blocks in the flowchart illustrations and/or block diagrams, can be implemented by computer program instructions. These computer program instructions may be provided to a processor of a general purpose computer, special purpose computer, or other programmable data processing apparatus to produce a machine, such that the instructions, which execute via the processor of the computer or other programmable data processing apparatus, create means for implementing the functions/acts specified in the flowchart and/or block diagram block or blocks.

The flowchart and block diagrams in the Figures illustrate the architecture, functionality and operation of possible implementations of systems, methods and computer program products according to various embodiments. In this regard, each block in the flowchart or block diagrams may represent a module, segment or portion of code, which comprises one or more executable instructions for implementing the specified logical function(s). It should also be noted that, in some alternative implementations, the functions noted in the block may occur out of the order noted in the figures. For example, two blocks shown in succession may, in fact, be executed substantially concurrently, or the blocks may sometimes be executed in the reverse order, depending upon the functionality involved. It will also be noted that each block of the block diagrams and/or flowchart illustration, and combinations of blocks in the block diagrams and/or flowchart illustration, can be implemented by special purpose hardware-based systems that perform the specified functions or acts, or combinations of special purpose hardware and computer instructions.

In view of the foregoing, the scope of the present 2. invention is determined by the claims that follow.

## Claims

1. A method (700) for managing power storage and discharge from a storage array (120) including a first group of power storage units and a second group of power storage units, the method comprising:
monitoring (710) operational characteristics of members of the first group of power storage units and members of the second group of power storage units;
monitoring (720) demand characteristics of power demand on the storage array, wherein the first group of power storage units is activated to supply power for a first component of the power demand and the second group of power storage units is activated to supply power for a second component of the power demand; and
while the members of the first group of power storage units and the members of the second group of power storage units remain installed and available to respond to the power demand on the storage array:
reassigning (740) a given member of the first group of power storage units to be a new member of the second group of power storage units in response to at least one of a change in the operational characteristics or a change in the demand characteristics,
the method being **characterised in** further comprising segmenting the power demand into a fast discharge component and a slow discharge component; and
wherein the first group of power storage units are designated for handling the fast discharge component and the second group of power storage units are designated for handling the slow discharge component.

2. The method of claim 1, wherein the given member has operational characteristics matching an operational definition for the first group of power storage units despite being assigned as the new member of the second group of power storage units.

3. The method of any of claims 1 or 2, wherein the given member is reassigned based on an operational characteristic change in an existing member of the second group of power storage units that causes the existing member to be reassigned to a different group of power storage units.

4. The method of claim 3, wherein the existing member is reassigned to be a member of one of:
the first group of power storage units; or
a third group of power storage units.

5. The method of any of claims 1-4, wherein the given member is reassigned based on a demand characteristic change requiring fewer members to meet the power demand on the first group of power storage units.

6. The method of any of claims 1-5, wherein the given member is reassigned based on a demand characteristic change requiring more members to meet the power demand on the second group of power storage units.

7. A system (800) for managing power storage and discharge from a storage array (120) including a first group of power storage units and a second group of power storage units, the system comprising:
a processor (810); and
a memory (820) device including instructions embodied therewith that when executed by the processor perform an operation comprising:
monitoring (710) operational characteristics of members of the first group of power storage units and members of the second group of power storage units;
monitoring (720) demand characteristics of power demand on the storage array, wherein the first group of power storage units is activated to supply power for a first component of the power demand and the second group of power storage units is activated to supply power for a second component of the power demand;
and
while the members of the first group of power storage units and the members of the second group of power storage units remain installed and available to respond to the power demand on the storage array:
reassigning (740) a given member of the first group of power storage units to be a new member of the second group of power storage units in response to at least one of a change in the operational characteristics or a change in the demand characteristics,
the system being **characterised in that** the operation further comprising:
segmenting the power demand into a fast discharge component and a slow discharge component; and
wherein the first group of power storage units are designated for handling the fast discharge component and the second group of power storage units are designated for handling the slow discharge component.

8. The system of claim 7, wherein the given member has operational characteristics matching an operational definition for the first group of power storage units despite being assigned as the new member of the second group of power storage units.

9. The system of any of claims 7 or 8, wherein the given member is reassigned based on an operational characteristic change in an existing member of the second group of power storage units that causes the existing member to be reassigned to a different group of power storage units.

10. The system of claim 9, wherein the existing member is reassigned to be a member of one of:
the first group of power storage units; or
a third group of power storage units.

11. The system of any of claims 7-10, wherein the given member is reassigned based on a demand characteristic change requiring fewer members to meet the power demand on the first group of power storage units.

12. The system of any of claims 7-11, wherein the given member is reassigned based on a demand characteristic change requiring more members to meet the power demand on the second group of power storage units.

## Patentansprüche

1. Verfahren (700) zum Verwalten von Leistungsspeicherung und -entladung aus einer Speicheranordnung (120), die eine erste Gruppe von Leistungsspeichereinheiten und eine zweite Gruppe von Leistungsspeichereinheiten einschließt, wobei das Verfahren umfasst:
Überwachen (710) von Betriebsmerkmalen von Mitgliedern der ersten Gruppe von Leistungsspeichereinheiten und Mitgliedern der zweiten Gruppe von Leistungsspeichereinheiten;
Überwachen (720) von Bedarfsmerkmalen von Leistungsbedarf an der Speicheranordnung, wobei die erste Gruppe von Leistungsspeichereinheiten aktiviert wird, um Leistung für eine erste Komponente des Leistungsbedarfs zu liefern, und die zweite Gruppe von Leistungsspeichereinheiten aktiviert wird, um Leistung für eine zweite Komponente des Leistungsbedarfs zu liefern; und
während die Mitglieder der ersten Gruppe von Leistungsspeichereinheiten und die Mitglieder der zweiten Gruppe von Leistungsspeichereinheiten installiert und verfügbar bleiben, um auf den Leistungsbedarf an der Speicheranordnung zu reagieren:
Neuzuweisen (740) eines gegebenen Mitglieds der ersten Gruppe von Leistungsspeichereinheiten, sodass es ein neues Mitglied der zweiten Gruppe von Leistungsspeichereinheiten ist, in Reaktion auf mindestens eines von einer Änderung der Betriebsmerkmale oder einer Änderung der Bedarfsmerkmale,
wobei das Verfahren **dadurch gekennzeichnet ist, dass** es weiter das Segmentieren des Leistungsbedarfs in eine Schnellentladekomponente und eine Langsamentladekomponente umfasst; und
wobei die erste Gruppe von Leistungsspeichereinheiten zum Handhaben der Schnellentladekomponente bestimmt sind und die zweite Gruppe von Leistungsspeichereinheiten zum Handhaben der Langsamentladekomponente bestimmt sind.

2. Verfahren nach Anspruch 1, wobei das gegebene Mitglied Betriebsmerkmale aufweist, die mit einer Betriebsdefinition für die erste Gruppe von Leistungsspeichereinheiten übereinstimmen, obwohl es als neues Mitglied der zweiten Gruppe von Leistungsspeichereinheiten zugewiesen ist.

3. Verfahren nach einem der Ansprüche 1 oder 2, wobei das gegebene Mitglied auf Grundlage einer Änderung von Betriebsmerkmalen bei einem bestehenden Mitglied der zweiten Gruppe von Leistungsspeichereinheiten neu zugewiesen wird, welche bewirkt, dass das bestehende Mitglied einer anderen Gruppe von Leistungsspeichereinheiten neu zugewiesen wird.

4. Verfahren nach Anspruch 3, wobei das bestehende Mitglied neu zugewiesen wird, sodass es ein Mitglied ist von einem von:
der ersten Gruppe von Leistungsspeichereinheiten; oder
einer dritten Gruppe von Leistungsspeichereinheiten.

5. Verfahren nach einem der Ansprüche 1-4, wobei das gegebene Mitglied auf Grundlage einer Änderung von Bedarfsmerkmalen, welche weniger Mitglieder erfordert, um den Leistungsbedarf an der ersten Gruppe von Leistungsspeichereinheiten zu decken, neu zugewiesen wird.

6. Verfahren nach einem der Ansprüche 1-5, wobei das gegebene Mitglied auf Grundlage einer Änderung von Bedarfsmerkmalen, welche mehr Mitglieder erfordert, um den Leistungsbedarf an der zweiten Gruppe von Leistungsspeichereinheiten zu decken, neu zugewiesen wird.

7. System (800) zum Verwalten von Leistungsspeicherung und -entladung aus einer Speicheranordnung (120), die eine erste Gruppe von Leistungsspeichereinheiten und eine zweite Gruppe von Leistungsspeichereinheiten einschließt, wobei das System umfasst:
einen Prozessor (810); und
eine Speichervorrichtung (820), die darin verkörperte Anweisungen einschließt, die, wenn sie von dem Prozessor ausgeführt werden, eine Operation durchführen, welche umfasst:
Überwachen (710) von Betriebsmerkmalen von Mitgliedern der ersten Gruppe von Leistungsspeichereinheiten und Mitgliedern der zweiten Gruppe von Leistungsspeichereinheiten;
Überwachen (720) von Bedarfsmerkmalen von Leistungsbedarf an der Speicheranordnung, wobei die erste Gruppe von Leistungsspeichereinheiten aktiviert wird, um Leistung für eine erste Komponente des Leistungsbedarfs zu liefern, und die zweite Gruppe von Leistungsspeichereinheiten aktiviert wird, um Leistung für eine zweite Komponente des Leistungsbedarfs zu liefern; und
während die Mitglieder der ersten Gruppe von Leistungsspeichereinheiten und die Mitglieder der zweiten Gruppe von Leistungsspeichereinheiten installiert und verfügbar bleiben, um auf den Leistungsbedarf an der Speicheranordnung zu reagieren:
Neuzuweisen (740) eines gegebenen Mitglieds der ersten Gruppe von Leistungsspeichereinheiten, sodass es ein neues Mitglied der zweiten Gruppe von Leistungsspeichereinheiten ist, in Reaktion auf mindestens eines von einer Änderung der Betriebsmerkmale oder einer Änderung der Bedarfsmerkmale,
wobei das System **dadurch gekennzeichnet ist, dass** die Operation weiter umfasst:
Segmentieren des Leistungsbedarfs in eine Schnellentladekomponente und eine Langsamentladekomponente; und
wobei die erste Gruppe von Leistungsspeichereinheiten zum Handhaben der Schnellentladekomponente bestimmt sind und die zweite Gruppe von Leistungsspeichereinheiten zum Handhaben der Langsamentladekomponente bestimmt sind.

8. System nach Anspruch 7, wobei das gegebene Mitglied Betriebsmerkmale aufweist, die mit einer Betriebsdefinition für die erste Gruppe von Leistungsspeichereinheiten übereinstimmen, obwohl es als neues Mitglied der zweiten Gruppe von Leistungsspeichereinheiten zugewiesen ist.

9. System nach einem der Ansprüche 7 oder 8, wobei das gegebene Mitglied auf Grundlage einer Änderung von Betriebsmerkmalen bei einem bestehenden Mitglied der zweiten Gruppe von Leistungsspeichereinheiten neu zugewiesen wird, welche bewirkt, dass das bestehende Mitglied einer anderen Gruppe von Leistungsspeichereinheiten neu zugewiesen wird.

10. System nach Anspruch 9, wobei das bestehende Mitglied neu zugewiesen wird, sodass es ein Mitglied ist von einem von:
der ersten Gruppe von Leistungsspeichereinheiten; oder
einer dritten Gruppe von Leistungsspeichereinheiten.

11. System nach einem der Ansprüche 7-10, wobei das gegebene Mitglied auf Grundlage einer Änderung von Bedarfsmerkmalen, welche weniger Mitglieder erfordert, um den Leistungsbedarf an der ersten Gruppe von Leistungsspeichereinheiten zu decken, neu zugewiesen wird.

12. System nach einem der Ansprüche 7-11, wobei das gegebene Mitglied auf Grundlage einer Änderung von Bedarfsmerkmalen, welche mehr Mitglieder erfordert, um den Leistungsbedarf an der zweiten Gruppe von Leistungsspeichereinheiten zu decken, neu zugewiesen wird.

## Revendications

1. Procédé (700) pour gérer un stockage et une décharge de puissance à partir d'un réseau de stockage (120) incluant un premier groupe d'unités de stockage de puissance et un deuxième groupe d'unités de stockage de puissance, le procédé comprenant :
la surveillance (710) de caractéristiques opérationnelles d'éléments du premier groupe d'unités de stockage de puissance et d'éléments du deuxième groupe d'unités de stockage de puissance ;
la surveillance (720) de caractéristiques de demande d'une demande de puissance sur le réseau de stockage, dans lequel le premier groupe d'unités de stockage de puissance est activé pour fournir de la puissance pour un premier composant de la demande de puissance et le deuxième groupe d'unités de stockage de puissance est activé pour fournir de la puissance pour un second composant de la demande de puissance ; et
pendant que les éléments du premier groupe d'unités de stockage de puissance et les éléments du deuxième groupe d'unités de stockage de puissance restent installés et disponibles pour répondre à la demande de puissance sur le réseau de stockage :
la réaffectation (740) d'un élément donné du premier groupe d'unités de stockage de puissance pour être un nouveau élément du deuxième groupe d'unités de stockage de puissance à la suite d'au moins un d'un changement des caractéristiques opérationnelles ou d'un changement des caractéristiques de demande,
le procédé étant **caractérisé en ce qu'**il comprend en outre la segmentation de la demande de puissance en un composant à décharge rapide et un composant à décharge lente ; et
dans lequel le premier groupe d'unités de stockage de puissance est désigné pour gérer le composant à décharge rapide et le deuxième groupe d'unités de stockage de puissance est désigné pour gérer le composant à décharge lente.

2. Procédé selon la revendication 1, dans lequel l'élément donné présente des caractéristiques opérationnelles correspondant à une définition opérationnelle pour le premier groupe d'unités de stockage de puissance bien qu'il soit affecté en tant que nouvel élément du deuxième groupe d'unités de stockage de puissance.

3. Procédé selon l'une quelconque des revendications 1 et 2, dans lequel l'élément donné est réaffecté sur la base d'un changement de caractéristique opérationnelle dans un élément existant du deuxième groupe d'unités de stockage de puissance qui amène l'élément existant à être réaffecté à un groupe différent d'unités de stockage de puissance.

4. Procédé selon la revendication 3, dans lequel l'élément existant est réaffecté pour être élément de l'un :
du premier groupe d'unités de stockage de puissance ; ou
d'un troisième groupe d'unités de stockage de puissance.

5. Procédé selon l'une quelconque des revendications 1-4, dans lequel l'élément donné est réaffecté sur la base d'un changement de caractéristique de demande nécessitant moins d'éléments pour répondre à la demande de puissance sur le premier groupe d'unités de stockage de puissance.

6. Procédé selon l'une quelconque des revendications 1-5, dans lequel l'élément donné est réaffecté sur la base d'un changement de caractéristique de demande nécessitant davantage d'éléments pour répondre à la demande de puissance sur le deuxième groupe d'unités de stockage de puissance.

7. Système (800) pour gérer un stockage et une décharge de puissance à partir d'un réseau de stockage (120) incluant un premier groupe d'unités de stockage de puissance et un deuxième groupe d'unités de stockage de puissance, le système comprenant :
un processeur (810) ; et
un dispositif de mémoire (820) incluant des instructions incorporées à celui-ci qui, lorsqu'elles sont exécutées par le processeur, effectuent une opération comprenant :
la surveillance (710) de caractéristiques opérationnelles d'éléments du premier groupe d'unités de stockage de puissance et d'éléments du deuxième groupe d'unités de stockage de puissance ;
la surveillance (720) de caractéristiques de demande d'une demande de puissance sur le réseau de stockage, dans lequel le premier groupe d'unités de stockage de puissance est activé pour fournir de la puissance pour un premier composant de la demande de puissance et le deuxième groupe d'unités de stockage de puissance est activé pour fournir de la puissance pour un second composant de la demande de puissance ; et
pendant que les éléments du premier groupe d'unités de stockage de puissance et les éléments du deuxième groupe d'unités de stockage de puissance restent installés et disponibles pour répondre à la demande de puissance sur le réseau de stockage :
la réaffectation (740) d'un élément donné du premier groupe d'unités de stockage de puissance pour être un nouveau élément du deuxième groupe d'unités de stockage de puissance à la suite d'au moins un d'un changement des caractéristiques opérationnelles ou d'un changement des caractéristiques de demande,
le système étant **caractérisé en ce que** l'opération comprend en outre :
la segmentation de la demande de puissance en un composant à décharge rapide et un composant à décharge lente ; et
dans lequel le premier groupe d'unités de stockage de puissance est désigné pour gérer le composant à décharge rapide et le deuxième groupe d'unités de stockage de puissance est désigné pour gérer le composant à décharge lente.

8. Système selon la revendication 7, dans lequel l'élément donné présente des caractéristiques opérationnelles correspondant à une définition opérationnelle pour le premier groupe d'unités de stockage de puissance bien qu'il soit affecté en tant que nouveau élément du deuxième groupe d'unités de stockage de puissance.

9. Système selon l'une quelconque des revendications 7 et 8, dans lequel l'élément donné est réaffecté sur la base d'un changement de caractéristique opérationnelle dans un élément existant du deuxième groupe d'unités de stockage de puissance qui amène l'élément existant à être réaffecté à un groupe différent d'unités de stockage de puissance.

10. Système selon la revendication 9, dans lequel l'élément existant est réaffecté pour être un élément de l'un :
du premier groupe d'unités de stockage de puissance ; ou
d'un troisième groupe d'unités de stockage de puissance.

11. Système selon l'une quelconque des revendications 7-10, dans lequel l'élément donné est réaffecté sur la base d'un changement de caractéristique de demande nécessitant moins d'éléments pour répondre à la demande de puissance sur le premier groupe d'unités de stockage de puissance.

12. Système selon l'une quelconque des revendications 7-11, dans lequel l'élément donné est réaffecté sur la base d'un changement de caractéristique de demande nécessitant davantage d'éléments pour répondre à la demande de puissance sur le deuxième groupe d'unités de stockage de puissance.
